Europäisches Patentamt

European Patent Office

Office européen des brevets

(19)

(11) **EP 1 330 885 B1**

(12) **EUROPÄISCHE PATENTSCHRIFT**

(45) Veröffentlichungstag und Bekanntmachung des Hinweises auf die Patenterteilung:
**08.06.2005 Patentblatt 2005/23**

(21) Anmeldenummer: **01976026.3**

(22) Anmeldetag: **06.09.2001**

(51) Int Cl.$^7$: **H04B 7/005**, H03G 3/30

(86) Internationale Anmeldenummer:
**PCT/DE2001/003482**

(87) Internationale Veröffentlichungsnummer:
**WO 2002/031992 (18.04.2002 Gazette 2002/16)**

(54) **SIGNALSTÄRKEAUSGLEICH FUR STARK ZEITVARIANTE MOBILFUNKKÄNALE**

SIGNAL STRENGTH COMPENSATION FOR MOBILE RADIO CHANNELS THAT CONSIDERABLY VARY WITH TIME

COMPENSATION D'INTENSITE DE SIGNAUX POUR CANAUX DE TELEPHONIE MOBILE TRES VARIABLES DANS LE TEMPS

(84) Benannte Vertragsstaaten:
**DE FR GB**

(30) Priorität: **11.10.2000 DE 10050330**

(43) Veröffentlichungstag der Anmeldung:
**30.07.2003 Patentblatt 2003/31**

(73) Patentinhaber: **Infineon Technologies AG
81669 München (DE)**

(72) Erfinder: **YANG, Bin
D-70550 Stuttgart (DE)**

(74) Vertreter: **Lange, Thomas, Dr. et al
Patentanwälte
Lambsdorff & Lange,
Dingolfinger Strasse 6
81673 München (DE)**

(56) Entgegenhaltungen:
EP-A- 0 564 850     US-A- 5 083 304
US-A- 5 287 556     US-A- 5 301 364

**Beschreibung**

Die Erfindung betrifft eine Empfangseinheit für die Mobilfunkübertragung, sowie eine Vorrichtung und ein Verfahren zum Signalstärkeausgleich in einem Mobilfunkempfänger.

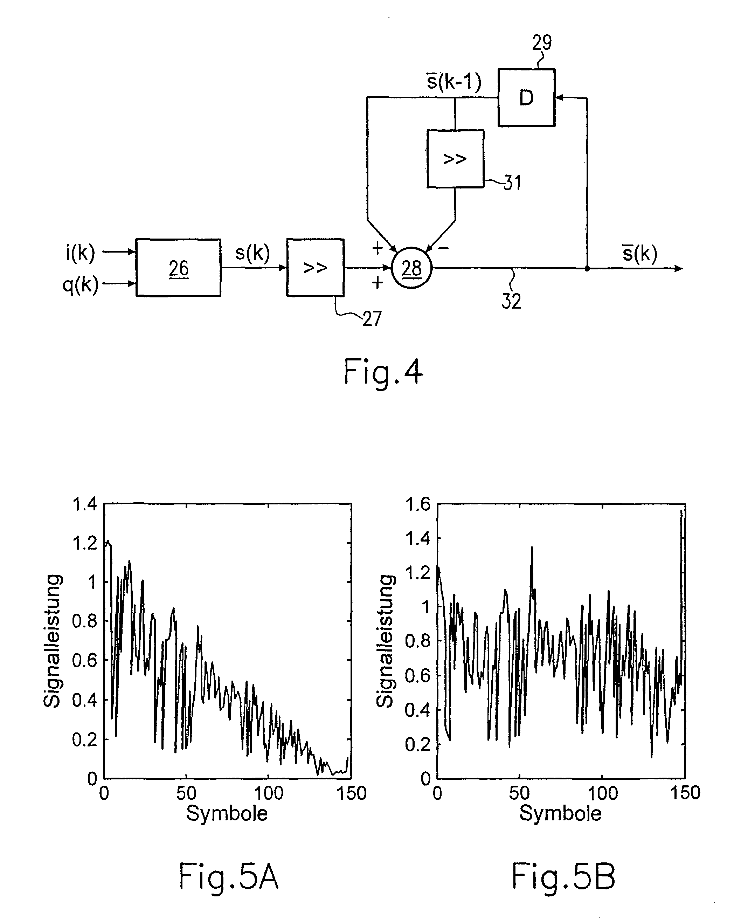

Bei der Übertragung von Datensignalen über einen Mobilfunkkanal treten charakteristische Leistungsschwankungen auf, die eine Entzerrung der empfangenen Signale erschweren. Beispielsweise verursacht eine Zunahme der Distanz zwischen Handy und Feststation eine kontinuierliche Abnahme der Leistung der empfangenen Signale. Neben derartigen langsamen Variationen der Signalleistung treten jedoch insbesondere in ländlichen Gebieten kurzfristige Signalleistungsschwankungen auf, und zwar insbesondere dann, wenn das Handy mit großer Geschwindigkeit bewegt wird (beispielsweise im Auto). Diese kurzfristigen Schwankungen treten insbesondere dann auf, wenn der direkte Übertragungspfad zwischen Sender und Empfänger von Zeit zu Zeit durch auftauchende Hindernisse verschattet wird. Wie aus Fig. 5A erkennbar ist, sind diese Signalstärkeschwankungen von so kurzer Zeitdauer, daß selbst innerhalb eines einzigen Datenbursts die Leistung der empfangenen Signale stark schwankt.

Es sind verschiedene Methoden zur Leistungsangleichung von empfangenen Mobilfunksignalen vorgeschlagen worden. Bei der sogenannten Automatic Gain Control (AGC) werden die empfangenen Signale eines Bursts mit einem pro Burst festgelegten Multiplikator skaliert. Bursts mit niedriger Signalleistung werden dadurch angehoben, während Bursts mit hoher Signalstärke gedämpft werden. Auf diese Weise ist es möglich, die mittlere Signalleistung der Bursts konstant zu halten. Es ist aber mit AGC nicht möglich, kurzfristige Leistungsschwankungen innerhalb eines Bursts auszugleichen.

Aus der Schrift US 5,083,304 ist eine auf AGC basierende Schaltung zur Anpassung der Signalstärke bekannt. Diese Schaltung umfasst einen analogen Verstärker mit veränderbarem Verstärkungsfaktor, dessen Verstärkung durch ein digital/analog-gewandeltes Ausgangssignal eines digitalen Leistungsreglers bestimmt wird. Das Ausgangssignal des analogen Verstärkers wird demoduliert, analog/digital-gewandelt und dann dem Leistungsregler zugeführt. Das Ausgangssignal des digitalen Leistungsverstärkers wird bestimmt, indem das Eingangssignal des Leistungsreglers selektiv zeitlich gemittelt wird, dieses Signal anschließend mit der inversen Übertragungsfunktion der Leistungssteuerung des analogen Verstärkers gefiltert wird und das gefilterte Signal mit dem Ausgangsignal zu einem vorherigen Zeitpunkt verglichen wird.

Eine weitere Methode zur Kompensation von Signalstärkeschwankungen ist das sogenannte Channel Tracking. Bei dieser Methode werden die Kanalkoeffizienten, die das Kanalverhalten modellieren, in regelmäßigen Abständen neu bestimmt. Dadurch ist es möglich, Leistungsschwankungen der empfangenen Signale bei der Entzerrung zu berücksichtigen.

Beim segmentbasierten Channel Tracking wird nach jedem empfangenen Datensegment eine neue Kanalschätzung durchgeführt. Dagegen werden beim symbolbasierten Channel Tracking die Kanalkoeffizienten permanent an die aktuellen Übertragungsbedingungen angepaßt. Zur Neubestimmung der Kanalkoeffizienten wird üblicherweise die Methode der minimalen Fehlerquadrate (Least Mean Square Algorithmus) verwendet, der die Kanalkoeffizienten ausgehend von der Lernfolge iterativ bestimmt.

Die Geschwindigkeit, mit der der LMS-Algorithmus konvergiert, wird durch die Schrittweite des Algorithmus festgelegt. Schnelle Signalstärkeschwankungen können nur dann verfolgt werden, wenn die Schrittweite entsprechend groß gewählt wird. Dies ist jedoch aus mehreren Gründen nicht praktikabel. Bei Verwendung einer großen Schrittweite kommt es häufig zu einem Divergieren des LMS-Algorithmus, so daß die neuen Kanalkoeffizienten nicht ermittelt werden können. Ein weiteres Problem bei der Verwendung großer Schrittweiten ist, daß es gelegentlich zu einer so starken Verstärkung des Rauschens kommt, daß das Ergebnis der Kanalschätzung unbrauchbar wird. Die Verwendung von Channel Tracking zum Ausgleich kurzfristiger Leistungsschwankungen kommt auch deshalb nicht in Frage, weil die hierfür notwendigen großen Schrittweiten zu einer deutlichen Verschlechterung der Nachführung bei schwach zeitvarianten Leistungsschwankungen führen. Channel Tracking ist daher auch bei Verwendung großer Schrittweiten ungeeignet zur Kompensation von kurzfristigen Leistungsschwankungen.

Der Erfindung liegt daher die Aufgabe zugrunde, eine Vorrichtung sowie ein Verfahren zum Signalstärkeausgleich bei einer Folge empfangener Signale zur Verfügung zu stellen, womit auch starke Signalstärkeschwankungen innerhalb eines Bursts verarbeitet werden können.

Diese Aufgabe der Erfindung wird durch eine Vorrichtung zum Signalstärkeausgleich gemäß Anspruch 1, durch eine Empfangseinheit für die Mobilfunkübertragung gemäß Anspruch 17 sowie durch ein Verfahren zum Signalstärkeausgleich gemäß Anspruch 18 gelöst.

Die erfindungsgemäße Vorrichtung zum Signalstärkeausgleich bei einer Folge empfangener digitaler Signalwerte weist Mittel zur Signalstärkebestimmung auf, welche einen für die Signalstärke des aktuellen Signalwerts repräsentativen Signalstärkewert erzeugen. Die Vorrichtung umfasst Mittel zur Berechnung eines dem aktuellen Signalwert nachgeführten Signalstärke-Mittelwerts aus bisherigen Signalwerten der Folge. Darüber hinaus umfaßt die Vorrichtung zum Signalstärkeausgleich digital arbeitende Mittel zur Signalstärkeanpassung, welche den aktuellen Signalwert mittels Berechnung an den bestimmten Signalstärke-Mittelwert derart angleichen, dass ein Signalwert, dessen Signalstärke kleiner als der nachgeführte Signalstärke-Mittelwert ist, angehoben wird, während ein Signalwert, dessen Signalstärke größer als der nachgeführte Signalstärke-Mittelwert ist, abgeschwächt wird.

Bezogen auf einen Datenburst bedeutet dies, daß der Signalstärke-Mittelwert aus den bisherigen Signalwerten des Bursts bestimmt wird und daher ständig (mit einer gewissen Trägheit) dem aktuellen Signal nachgeführt wird. Dadurch können auch kurzfristige Signalstärkeschwankungen innerhalb eines Datenbursts ausgeglichen werden. Ein Signalwert, dessen Signalstärke kleiner ist als das bisherige Mittel, wird angehoben, während ein Signalwert mit über dem Mittel liegenden Signalstärkewert abgeschwächt wird. Dadurch werden die Schwankungen der Signalleistung verkleinert, und die nachgeschaltete Kanalschätzung und Kanalentzerrung verbessert sich.

Die erfindungsgemäße Vorrichtung zum Signalstärkeausgleich ermöglicht eine signifikante Absenkung der auf die Sendeleistung bezogenen Bitfehlerrate. Eine vorgegebene Bitfehlerrate läßt sich in einigen Fällen mit einer um bis zu 3 dB abgesenkten Sendeleistung erzielen.

Im Unterschied zum vorbekannten Verfahren Automatic Gain Control (AGC) lassen sich mit der erfindungsgemäßen Vorrichtung zum Signalstärkeausgleich auch die innerhalb eines Bursts auftretenden kurzfristigen, beispielsweise durch Abschattung des Empfangspfads verursachten Signalstärkeschwankungen ausgleichen. Da der nachgeschaltete Kanalentzerrer bereits die signalstärkeangepaßten Empfangssignale verarbeitet, werden Konvergenzprobleme bei der Bestimmung der Kanalkoeffizienten vermieden.

Die Signalstärkeanpassung an den Signalstärke-Mittelwert läßt die Phasen der empfangenen Signalwerte unverändert. Das Empfangssignal wird phasenrichtig korrigiert, und deshalb kann die Verarbeitung der signalstärkekorrigierten Signalwerte durch den nachgeschalteten Kanalschätzer und Kanalentzerrer in bekannter Art und Weise erfolgen.

Die erfindungsgemäße Empfangseinheit für die Mobilfunkübertragung umfaßt einen Kanalschätzer, der die Kanalkoeffizienten $h_0,...h_L$ zur Modellierung des Übertragungskanals ermittelt, sowie einen Kanalentzerrer, der unter Verwendung der vom Kanalschätzer ermittelten Kanalkoeffizienten die empfangenen Signalwerte entzerrt.

Darüber hinaus weist die erfindungsgemäße Empfangseinheit eine dem Kanalschätzer und dem Kanalentzerrer vorgeschaltete Vorrichtung zum Signalstärkeausgleich nach einem der Ansprüche 1 bis 16 auf. Wie oben beschrieben, umfaßt die Vorrichtung zum Signalstärkeausgleich Mittel zur Signalstärkebestimmung, Mittel zur Berechnung eines nachgeführten Signalstärke-Mittelwerts sowie Mittel zur Signalstärkeanpassung. Während gemäß dem Stand der Technik die stark zeitvarianten Empfangssignale für die Kanalschätzung herangezogen werden, werden bei der erfindungsgemäßen Lösung die Kanalkoeffizienten anhand von signalstärkekorrigierten Signalen bestimmt. Auch dem Kanalentzerrer werden die korrigierten Signalwerte zugeführt, die dann entsprechend den vom Kanalschätzer ermittelten Kanalkoeffizienten entzerrt werden. Die vorgeschaltete Vorrichtung zum Signalstärkeausgleich vermag kurzzeitige Leistungsschwankungen des Empfangssignals wesentlich effektiver auszugleichen, als dies durch ständige Nachführung der Kanalschätzung möglich wäre. Da der Signalstärkeausgleich unter Beibehaltung der Phasen der Signalwerte durchgeführt wird, können für die Kanalentzerrung die korrigierten Signalwerte verwendet werden.

Gemäß einer vorteilhaften Ausführungsform der Erfindung teilen die Mittel zur Signalstärkeanpassung den aktuellen Signalwert durch den Signalstärke-Mittelwert. Der Signalstärke-Mittelwert folgt dem Verlauf der Signalstärke mit einer gewissen Trägheit. Wenn das Empfangssignal mit hoher Leistung empfangen werden kann, dann hat auch der Signalstärke-Mittelwert einen hohen Wert, und insofern wird durch die Division der aktuelle Signalwert abgeschwächt. Umgekehrt nimmt bei schlechtem Empfang der Signalstärke-Mittelwert einen kleinen Wert an, und das schwache Empfangssignal wird durch die Division angehoben. Die Division des aktuellen Signalwerts durch den Signalstärke-Mittelwert stellt die einfachste Möglichkeit des Signalstärkeausgleichs dar.

Es ist von Vorteil, wenn die Mittel zur Signalstärkeanpassung den Signalstärke-Mittelwert jeweils aus den Signalstärkewerten der bisherigen Signalwerte der Folge einschließlich des Signalstärkewerts des aktuellen Signalwerts bestimmen. Bei dieser Vorgehensweise wird der aktuelle Signalwert bei der Mittelwertbildung berücksichtigt. Ein besonders großer bzw. besonders kleiner aktueller Wert hebt bzw. senkt unmittelbar den Signalstärke-Mittelwert. Dadurch wird ein effektiverer Signalstärkeausgleich ermöglicht.

Alternativ dazu kann es auch vorteilhaft sein, wenn die Mittel zur Signalstärkeanpassung den Signalstärke-Mittelwert jeweils aus den Signalstärkewerten der bisherigen Signalwerte der Folge ohne den Signalstärkewert des aktuellen Signalwerts bestimmen. Unter dem Gesichtspunkt der Verarbeitungsgeschwindigkeit ist diese Lösung die günstigere. Da der aktuelle Signalwert bei der Bildung des Signalstärke-Mittelwerts nicht berücksichtigt werden muß, steht der für die Skalierung verwendete Signalstärke-Mittelwert bereits bei Eintreffen des aktuellen Signalwerts zur Verfügung.

Es ist von Vorteil, wenn es sich bei den empfangenen Signalwerten um komplexe Signale handelt, die jeweils ein Inphase-Signal $i(k)$ und ein Quadratur-Signal $q(k)$ umfassen. Komplexwertige Signale sind der übliche Standard im Mobilfunkbereich.

Vorteilhafterweise teilen die Mittel zur Signalstärkeanpassung sowohl das Inphase-Signal $i(k)$ als auch das Quadratur-Signal $q(k)$ durch den Signalstärke-Mittelwert. Durch diese beiden Divisionen wird erreicht, daß der Betrag des Gesamtsignals auf den Signalstärke-Mittelwert normiert wird.

Es ist von Vorteil, wenn die Mittel zur Signalstärkebestimmung den für die Signalstärke eines Signalwerts repräsentativen Signalstärkewert durch Addition des Betrags des Inphase-Signals i(k) und des Betrags des Quadratur-Signals q(k) bestimmen. Der Betrag des jeweiligen Signalwerts kann auf sehr einfache Weise dadurch erhalten werden, daß das Vorzeichen der jeweiligen Komponente bei der Addition nicht berücksichtigt wird. Bei dieser Ausführungsform der Erfindung ist keine Quadrierung des Inphase- bzw. des Quadratur-Signals erforderlich, und deshalb stellt dies die einfachste Möglichkeit zur Bestimmung des Signalstärkewerts dar. Diese Methode der Signalstärkebestimmung erfordert insofern den geringsten Aufwand.

Alternativ dazu ist es von Vorteil, wenn die Mittel zur Signalstärkebestimmung den für die Signalstärke eines Signalwerts repräsentativen Signalstärkewert durch Addition des quadrierten Inphase-Signals $i(k)^2$ und des quadrierten Quadratur-Signals $q(k)^2$ bestimmen. Der Betrag komplexwertiger Signalwerte wird üblicherweise durch Addition der Betragsquadrate und anschließende Radizierung ermittelt, denn das Betragsquadrat des Gesamtsignals entspricht der Summe von quadriertem Realteil und quadriertem Imaginärteil. Bei der vorliegenden Erfindung kommt es nur darauf an, ein für die Signalstärke charakteristisches Maß zu erhalten. Deshalb kann auf die abschließende Radizierung auch verzichtet werden.

Vorteilhafterweise umfassen die Mittel zur Berechnung eines dem aktuellen Signalwert nachgeführten Signalstärke-Mittelwerts einen Addierer, der den aktuellen Signalstärke-Mittelwert durch Addition des mit $\lambda_1$ multiplizierten vorhergehenden Signalstärke-Mittelwerts und des mit $\lambda_2$ multiplizierten Signalstärke-Mittelwerts des aktuellen Signalwerts erzeugt, wobei $\lambda_1+\lambda_2=1$ gilt. Zum aktuellen Signalstärke-Mittelwert trägt also der vorhergehende Signalstärke-Mittelwert mit dem Anteil $\lambda_1$ und der aktuelle Signalstärkewert mit dem Anteil $\lambda_2$ bei. Eine derartige Mittelwertsbildung wird als exponentielle Mittelung bezeichnet. Frühere Signalwerte tragen um so weniger zum aktuellen Mittelwert bei, je weiter sie zurückliegen. Ihr Anteil am aktuellen Signalstärke-Mittelwert verblaßt mit $\lambda_2 \cdot \lambda_1^m$, wobei m eine natürliche Zahl ist und angibt, wie weit der frühere Signalwert zeitlich zurückliegt. Der aktuelle Signalstärkewert trägt mit dem Anteil $\lambda_2$ zum aktuellen Signalstärke-Mittelwert bei und liefert insofern den wichtigsten Beitrag zum Mittelwert. Die exponentielle Mittelung vermag dem Signalstärkeverlauf hinreichend gut zu folgen, so daß ein effektiver Signalstärkeausgleich erzielt werden kann.

Vorteilhafterweise umfassen die Mittel zur Berechnung eines dem aktuellen Signalwert nachgeführten Signalstärke-Mittelwerts ein Register für den Signalstärke-Mittelwert, welches jeweils den aktuellen Signalstärke-Mittelwert speichert und für die Berechnung des nächstfolgenden Signalstärke-Mittelwerts zur Verfügung stellt. Durch diese iterative Vorgehensweise muß der Signalstärke-Mittelwert nicht bei jedem Durchgang komplett neu berechnet werden. Statt dessen wird vom abgespeicherten vorherigen Mittelwert ausgegangen, um mit geringem Aufwand den aktuellen Signalstärke-Mittelwert zu bestimmen.

Vorteilhafterweise wird $\lambda_1=1-2^{-n}$ und $\lambda_2=2^{-n}$ gewählt, wobei n eine natürliche Zahl ist. Mit n kann das Gewicht des Beitrags der aktuellen Signalleistung zum Signalstärke-Mittelwert eingestellt werden. Je größer n gewählt wird, desto stärker ist der Beitrag der zurückliegenden Mittelwerte, und desto geringer ist der Beitrag des aktuellen Signalstärkewerts. Unabhängig von der Wahl von n ist stets $\lambda_1+\lambda_2=1$ gewährleistet.

Dabei kann die Multiplikation des Signalstärkewerts des aktuellen Signals mit $\lambda_2=2^{-n}$ in vorteilhafter Weise mittels eines Schieberegisters erfolgen. Entsprechend kann die Multiplikation des vorhergehenden Signalstärke-Mittelwerts mit $\lambda_1=1-2^{-n}$ in vorteilhafter Weise mittels eines Addierers und eines Schieberegisters erfolgen. Dabei wird jeweils ausgenützt, daß die n-fache Rechtsverschiebung einer Binärzahl mittels eines Schieberegisters einer Multiplikation mit $2^{-n}$ entspricht. Daher können an Stelle von Multiplizierern einfache Schieberegister verwendet werden, und dadurch wird eine einfache und kostengünstige Implementierung möglich.

Es ist von Vorteil, wenn die Mittel zur Signalstärkeanpassung den aktuellen Signalwert nur dann an den Signalstärke-Mittelwert angleichen, wenn die Variation der Signalstärke innerhalb der Folge eine vorgegebene Schwelle überschreitet. Falls die Signalstärke innerhalb des Bursts nur geringfügig schwankt, ist es in Hinblick auf die Bitfehlerrate von Vorteil, das Empfangssignal unverändert zu belassen. Das beste Gesamtergebnis wird erzielt, wenn die erfindungsgemäße Signalstärkeanpassung nur bei Bursts durchgeführt wird, bei denen die Schwankung der Signalstärke eine vorgegebene Schwelle übersteigt.

Dabei ist es insbesondere von Vorteil, wenn die Mittel zur Signalstärkeanpassung die jeweiligen aktuellen Signalwerte einer Folge nur dann an die jeweiligen Signalstärke-Mittelwerte der Folge angleichen, wenn sich der maximale Signalstärke-Mittel-wert der Folge und der mittlere Signalstärke-Mittelwert der Folge hinreichend stark unterscheiden. Bei dieser Ausführungsform der Erfindung müssen die zu einem Burst gehörigen Signalwerte gepuffert werden, damit der gemittelte und der maximale Signalstärke-Mittelwert bestimmt werden können. Anhand eines Vergleichs des gemittelten und des maximalen Signalstärke-Mittelwerts kann entschieden werden, ob der erfindungsgemäße Signalstärkeausgleich durchgeführt werden soll oder nicht.

Dabei ist es insbesondere von Vorteil, den Quotienten des maximalen Signalstärke-Mittelwerts und des mittleren Signalstärke-Mittelwerts der Folge zu berechnen und den Signalstärkeausgleich dann durchzuführen, wenn der Quotient einen vorgegebenen Schwellenwert überschreitet.

Nachfolgend wird die Erfindung anhand eines in der Zeichnung dargestellten Ausführungsbeispiels weiter beschrieben. Es zeigen:

Fig. 1 einen Mobilfunkempfänger entsprechend dem Stand der Technik, der einen Kanalschätzer sowie einen Kanalentzerrer aufweist;

Fig. 2 eine erfindungsgemäß modifizierte Empfangseinheit für die Mobilfunkübertragung, welche zusätzlich eine Signalstärke-Ausgleichseinheit aufweist;

Fig. 3 ein Blockschaltbild der erfindungsgemäßen Signalstärke-Ausgleichseinheit;

Fig. 4 eine vorteilhafte Ausführungsform, bei der der Signalstärke-Mittelwert mit Hilfe von Schieberegistern bestimmt wird;

Fig. 5A den Signalstärkeverlauf innerhalb eines stark zeitvarianten Datenbursts vor Durchführung des Signalstärkeausgleichs;

Fig. 5B den Signalstärkeverlauf des in Fig. 5A dargestellten Datenbursts nach Durchführung des Signalstärkeausgleichs.

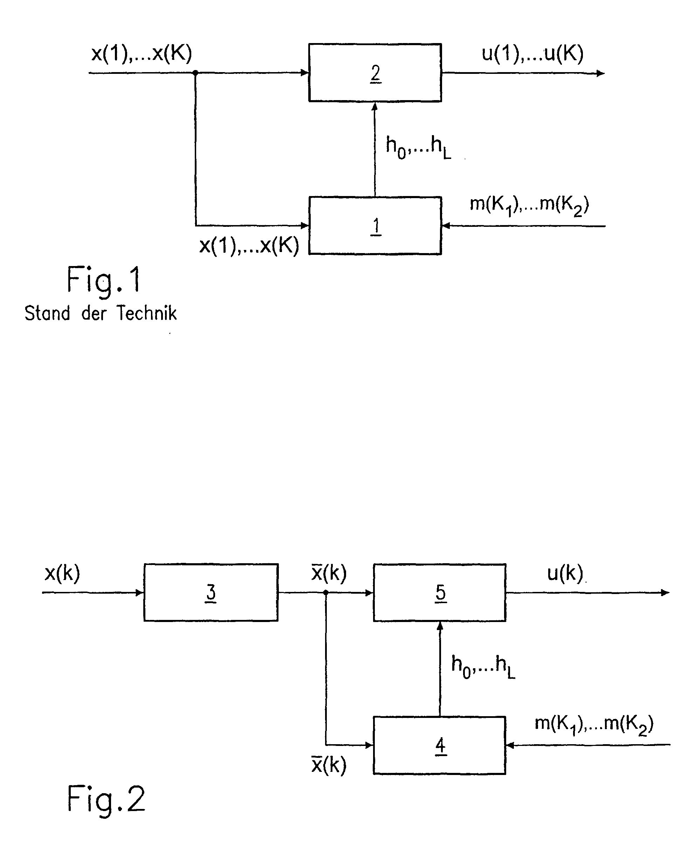

In Fig. 1 ist ein Mobilfunkempfänger gemäß dem Stand der Technik dargestellt, welcher einen Kanalschätzer 1 sowie einen Kanalentzerrer 2 umfaßt. Die empfangenen Datensymbole x(k) (k = 1, ... K) sind aufgrund der Multipfad-Übertragungscharakteristik des Mobilfunkkanals verzerrt. Die empfangenen, verzerrten Datensymbole x(k) werden dem Kanalschätzer 1 zugeführt, der die empfangenen Datensymbole mit den unverzerrten Datensymbolen der Trainingsfolge $m(K_1)$, ... $m(K_2)$ korreliert, um auf diese Weise die Kanalkoeffizienten $h_0$, ... $h_L$ zu bestimmen. L bezeichnet dabei das Gedächtnis des Kanals.

Die auf diese Weise ermittelten Kanalkoeffizienten stellen ein Modell des Übertragungsverhaltens des Kanals dar. Die Kanalkoeffizienten $h_0$, ...$h_L$ werden dem Kanalentzerrer 2 zugeführt, der mit ihrer Hilfe eine Entzerrung der empfangenen, verzerrten Datensymbole x(k) durchführt und so die entzerrten Datensymbole u(k) (k = 1, ... K) ermittelt. Die Entzerrung wird vorteilhafterweise mittels des Viterbi-Verfahrens durchgeführt.

Fig. 2 zeigt ein Blockschaltbild des erfindungsgemäß modifizierten Mobilfunkempfängers. Die empfangenen, verzerrten Datensymbole x(k) (k = 1, ... K) werden zunächst der Signalstärke-Ausgleichseinheit 3 zugeführt, die dem Kanalschätzer 4 und dem Kanalentzerrer 5 vorgeschaltet ist. Wenn die Signalstärkeschwankung innerhalb eines empfangenen Datenbursts eine vorgegebene Schwelle übersteigt, führt die Ausgleichseinheit 3 eine Signalstärkeanpassung der empfangenen Datensymbole x(k) durch. Auf diese Weise werden die immer noch verzerrten, aber signalstärkeangepaßten Datensymbole $\bar{x}(k)$ (k = 1, ... K) erhalten, die dem Kanalschätzer 4 und dem Kanalentzerrer 5 zugeführt werden. Ausgehend von diesen Datensymbolen $\bar{x}(k)$ ermittelt der Kanalschätzer 4 die Kanalkoeffizienten $h_0$, ... $h_L$, die er dem Kanalentzerrer 5 übermittelt. Dieses Kanalmodell wird dann bei der Entzerrung der Datensymbole $\bar{x}(k)$ zugrunde gelegt, um die entzerrten Datensymbole u(k) zu erhalten.

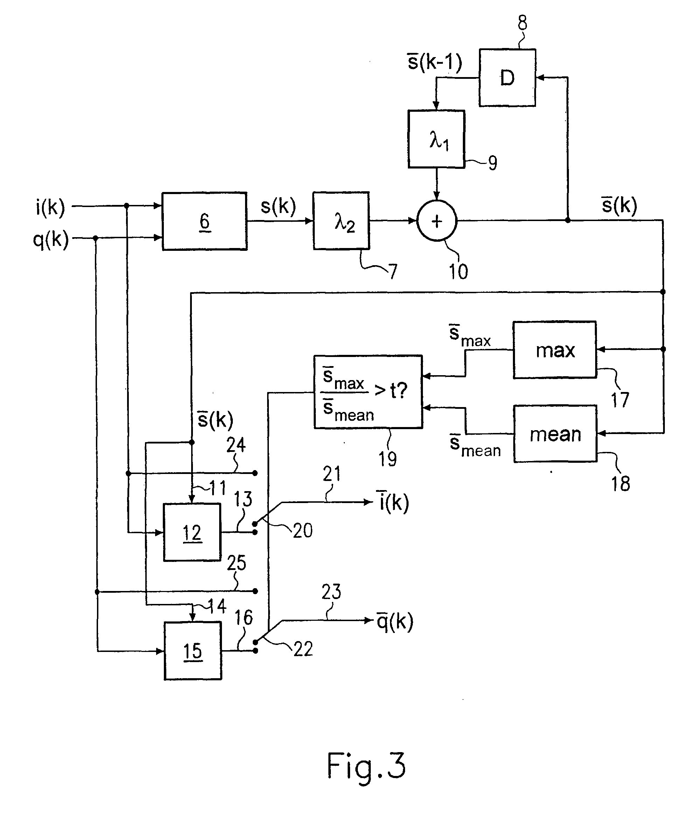

Die Funktionsweise der vorgeschalteten Signalstärke-Ausgleichseinheit 3 soll im folgenden anhand von Fig. 3 dargestellt werden. Die empfangenen Datensymbole x(k) sind komplexwertig und können insofern durch einen Inphase-Anteil i(k) sowie einen Quadratur-Anteil q(k) dargestellt werden:

$$x(k) = i(k) + i \cdot q(k)$$

Sowohl der Inphase- als der Quadratur-Anteil werden der Einheit 6 zur Signalstärkebestimmung zugeführt. Zur Berechnung der Signalstärke s(k) gibt es mehrere Möglichkeiten. Eine Möglichkeit ist, den quadrierten Inphase-Anteil und den quadrierten Quadratur-Anteil zu addieren, so daß gilt

$$s(k) = i(k)^2 + q(k)^2$$

Weniger rechenaufwendig ist es, zur Ermittlung der Signalstärke die Beträge

$$|i(k)|$$

und

$$|q(k)|$$

der beiden Signalanteile zu addieren, so daß sich die Signalstärke s(k) zu

$$s(k) = |i(k)| + |q(k)|$$

ergibt. Zur Berechnung des Betrags eines Signalanteils genügt es, das Vorzeichen des jeweiligen Signalanteils unberücksichtigt zu lassen.

Als nächstes wird der Signalstärke-Mittelwert $\bar{s}(k)$ zur Zeit k berechnet. Zur Mittelwertsbildung eignet sich insbesondere eine exponentielle Mittelung gemäß der Formel

$$\bar{s}(k) = \lambda_1 \cdot \bar{s}(k-1) + \lambda_2 \cdot s(k)$$

Hierbei bezeichnet $\bar{s}(k-1)$ den bisherigen Mittelwert der Signalstärke. Für die beiden Koeffizienten $\lambda_1$ und $\lambda_2$ gilt

$$0 < \lambda_1 < 1 \, , \, 0 < \lambda_2 < 1$$

sowie

$$\lambda_1 + \lambda_2 = 1$$

Insofern gibt der Faktor $\lambda_1$ den Beitrag des bisherigen Signalstärke-Mittelwerts zum neuen Signalstärke-Mittelwert an, während $\lambda_2$ den Beitrag des aktuellen Signalstärkewerts zum neuen Mittelwert angibt. Aus dieser Art der Mittelwertsbildung ergibt sich, daß die Beiträge früherer Signalstärkewerte s(k-2), s(k-3), ... s(k-m) um so weniger zum neuen Signalstärke-Mittelwert beitragen, je weiter sie zurückliegen. Der m Zeiteinheiten zurückliegende Signalstärkewert s(k-m) trägt nurmehr mit dem Faktor

$$\lambda_1^m$$

zum neuen Mittelwert bei.

Zur Berechnung des neuen Signalstärke-Mittelwerts wird der aktuelle Signalstärkewert s(k) durch den Multiplizierer 7 mit dem Faktor $\lambda_2$ multipliziert und anschließend dem Addierer 10 zugeführt. Der im Register 8 gespeicherte bisherige Signalstärke-Mittelwert $\bar{s}(k-1)$ wird durch den Multiplizierer 9 mit dem Faktor $\lambda_1$ multipliziert und anschließend ebenfalls dem Addierer 10 zugeleitet. Der Addierer 10 addiert die Terme

$$\lambda_1 \cdot \bar{s}(k-1)$$

und

$$\lambda_2 \cdot s(k)$$

und bestimmt so den neuen Signalstärke-Mittelwert $\bar{s}(k)$.

Der neue Signalstärke-Mittelwert $\bar{s}(k)$ wird im Register 8 gespeichert; außerdem wird der Signalstärke-Mittelwert $\bar{s}(k)$ über die Signalleitungen 11 und 14 den Dividiereinheiten 12 und 15 zugeführt. Das an der Dividiereinheit 12 anliegende Inphase-Signal i(k) wird durch den aktuellen Signalstärke-Mittelwert $\bar{s}(k)$ geteilt, um das korrigierte Inphase-Signal

$$\bar{i}(k) = \frac{i(k)}{\bar{s}(k)}$$

zu erhalten, das am Ausgang 13 der Dividiereinheit 12 anliegt. Entsprechend berechnet die Dividiereinheit 15 das korrigierte Quadratursignal

$$\bar{q}(k) = \frac{q(k)}{\bar{s}(k)}$$

das am Ausgang 16 der Dividiereinheit 15 erscheint.

Die besten Entzerrungsergebnisse werden erzielt, wenn nur stark zeitvariante Datenbursts einer Signalstärkekorrektur unterworfen werden. Für Datenbursts, die nur geringe Signalstärkeschwankungen aufweisen, wird kein Signalstärkeausgleich durchgeführt.

Um ein Maß für die Schwankung der Signalstärke innerhalb eines Datenbursts zu erhalten, wird ausgehend von den Signalstärke-Mittelwerten

$$\bar{s}(k)$$

mit k = 1, 2, ..., K der maximale Signalstärke-Mittelwert

$$\bar{s}_{max} = max\{\bar{s}(k)|k = 1,2,...,K\}$$

sowie der mittlere Signalstärke-Mittelwert

$$\bar{s}_{mean} = \frac{1}{K} \sum_{k=1}^{K} \bar{s}(k)$$

des Datenbursts bestimmt. K bezeichnet dabei die Anzahl der Datensymbole pro Datenburst.

Bei nur geringer Signalstärkeschwankung der empfangenen Datensymbole sind auch die Schwankungen der jeweils nachgeführten Signalstärke-Mittelwerte $\bar{s}(k)$ gering. Der maximale Signalstärke-Mittelwert $\bar{s}_{max}$ ist nur geringfügig größer als der mittlere Signalstärke-Mittelwert $\bar{s}_{mean}$. Bei starken Signalstärkeschwankungen innerhalb eines Datenbursts dagegen ist $\bar{s}_{max}$ wesentlich größer als $\bar{s}_{mean}$.

Insofern stellt der Quotient

$$\frac{\bar{s}_{max}}{\bar{s}_{mean}}$$

ein gutes Maß für die Signalstärkeschwankung innerhalb des betrachteten Datenbursts dar. Wenn dieser Quotient nur geringfügig größer als 1 ist, soll keine Signalstärkeanpassung erfolgen. Wenn dagegen der Quotient

$$\frac{\bar{s}_{max}}{\bar{s}_{mean}}$$

einen vorgegebenen Schwellwert t übersteigt, dann soll die erfindungsgemäße Signalstärke-Korrektur durchgeführt werden.

Bei der in Fig. 3 gezeigten Implementierung wird die erfindungsgemäße Signalstärkeanpassung nur selektiv bei starker Signalstärkeschwankung durchgeführt. Zu diesem Zweck sind ein Register 17 für den maximalen Signalstärke-Mittelwert $\bar{s}_{max}$ sowie ein Register 18 für den mittleren Signalstärke-Mittelwert $\bar{s}_{mean}$ vorgesehen. Die für einen bestimmten Datenburst ermittelten Werte von $\bar{s}_{max}$ und $\bar{s}_{mean}$ werden dem Vergleicher 19 zugeführt, der den Quoti-

enten

$$\frac{\bar{s}_{max}}{\bar{s}_{mean}}$$

berechnet und diesen mit dem Schwellwert t vergleicht. In Abhängigkeit vom Vergleichsergebnis werden die Schalter 20 und 22 gesteuert. Wenn

$$\frac{\bar{s}_{max}}{\bar{s}_{mean}} > t$$

gilt, dann ist der Ausgang 13 der Dividiereinheit 12 mit dem Ausgang 21 verbunden, und an diesem Ausgang 21 erscheint der korrigierte Wert

$$\bar{i}(k) = \frac{i(k)}{\bar{s}(k)}$$

Entsprechend ist der Ausgang 16 der Dividiereinheit 15 mit dem Ausgang 23 verbunden, an dem der Wert

$$\bar{q}(k) = \frac{q(k)}{\bar{s}(k)}$$

erscheint.
Bei geringen Signalstärkeschwankungen innerhalb des betrachteten Datenbursts gilt dagegen

$$\frac{\bar{s}_{max}}{\bar{s}_{mean}} \leq t$$

In diesem Fall soll keine Signalstärkekorrektur durchgeführt werden. Die Schalter 20 und 22 befinden sich in ihrer oberen Position. Der Schalter 20 verbindet die Signalleitung 24 mit dem Ausgang 21, an dem daher der unveränderte Wert i(k) erscheint. Entsprechend verbindet der Schalter 22 die Signalleitung 25 mit dem Ausgang 23, an dem der Wert q(k) auftritt.
Zusammenfassend gilt daher für die Werte $\bar{i}(k)$ und $\bar{q}(k)$ des Inphase- sowie des Quadratur-Signals nach Durchführung des Signalstärke-Ausgleichs:

$$\bar{i}(k) = \begin{cases} i(k) & \text{für} & \bar{s}_{max}/\bar{s}_{mean} \leq t \\ i(k)/\bar{s}(k) & \text{für} & \bar{s}_{max}/\bar{s}_{mean} > t \end{cases}$$

$$\bar{q}(k) = \begin{cases} q(k) & \text{für} & \bar{s}_{max}/\bar{s}_{mean} \leq t \\ q(k)/\bar{s}(k) & \text{für} & \bar{s}_{max}/\bar{s}_{mean} > t \end{cases}$$

Die Werte von $\bar{s}_{max}$ und von $\bar{s}_{mean}$ liegen erst nach vollständigem Empfang eines zu betrachtenden Datenbursts vor. Erst nach Auswertung der Signalstärken von sämtlichen empfangenen Datensymbolen eines Datenbursts kann entschieden werden, ob die erfindungsgemäße Signalstärkeanpassung durchgeführt werden soll oder nicht. Insofern ist es erforderlich, die empfangenen Datensymbole des Datenbursts in hierfür vorgesehenen Datenpuffern abzulegen. Diese Datenpuffer zur Speicherung der zum aktuellen Datenburst gehörigen Werte von i(k), q(k) (mit k = 1, 2, ..., K) sind in Fig. 3 aus Gründen der Übersichtlichkeit nicht dargestellt.

Zur Berechnung von

$$\bar{s}(k) = \lambda_1 \cdot \bar{s}(k - 1) + \lambda_2 \cdot s(k)$$

sind in Fig. 3 das Verzögerungsglied 8, die beiden Multiplizierer 7 und 9 und der Addierer 10 vorgesehen.
Gemäß einer vorteilhaften Ausführungsform werden

$$\lambda_1 = 1 - 2^{-n}$$

und

$$\lambda_2 = 2^{-n}$$

gesetzt, wobei n eine natürliche Zahl ist. Bei dieser Wahl von $\lambda_1$ und $\lambda_2$ ist sichergestellt, daß

$$\lambda_1 + \lambda_2 = 1$$

gilt. Der Vorteil bei dieser Wahl von $\lambda_1$ und $\lambda_2$ ist, daß die aufwendigen Multiplizierer 7 und 9 durch Rechtsverschieber ersetzt werden können.
Eine entsprechende Ausführungsform ist in Fig. 4 gezeigt. Die Einheit 26 zur Signalstärkebestimmung bestimmt aus den Werten von i(k) und q(k) die zugehörigen Signalstärken s(k). Zur Multiplikation dieser Signalstärkewerte mit

$$\lambda_2 = 2^{-n}$$

ist der Rechtsverschieber 27 vorgesehen, der das Bitmuster des Signalstärkewerts s(k) um n Positionen nach rechts verschiebt. Das Ergebnis der Rechtsverschiebung wird dem Addierer 28 zugeführt. Im Verzögerungsglied 29 ist der bisherige Signalstärke-Mittelwert $\bar{s}(k - 1)$ gespeichert. Dieser Wert soll mit

$$\lambda_1 = 1 - 2^{-n}$$

multipliziert werden. Dazu wird der Wert von $\bar{s}(k - 1)$ dem Addierer 28 zum einen unverändert über die Signalleitung 30 zugeführt. Zum anderen wird $\bar{s}(k - 1)$ durch den Rechtsverschieber 31 um n Positionen nach rechts verschoben; das Ergebnis dieser Rechtsverschiebung wird dem Addierer 28 mit negativem Vorzeichen zugeführt. Der Addierer 28 liefert am Ausgang 32 den neuen Signalstärke-Mittelwert

$$\bar{s}(k) = (1 - 2^{-n}) \cdot \bar{s}(k - 1) + 2^{-n} \cdot s(k),$$

der wiederum im Verzögerungsglied 29 abgespeichert wird.
Die Wirkungsweise des erfindungsgemäßen Signalstärkeausgleichs ist anhand der Fig. 5A und 5B dargestellt. In Fig. 5A ist der Signalstärkeverlauf für die Datensymbole eines Datenbursts dargestellt. Derartig ausgeprägte kurzfristige Schwankungen der Signalstärke sind nicht ungewöhnlich, da es häufig zu einer Abschattung des direkten Übertragungspfads zwischen Handy und Feststation kommt. Bei den in Fig. 5A gezeigten Daten handelt es sich um tatsächlich gemessene Signalstärken und nicht etwa um eine Simulation. In Fig. 5B ist der Signalstärkeverlauf für denselben Datenburst nach Durchführung des erfindungsgemäßen Signalstärkeausgleichs dargestellt. Wieder handelt es sich um tatsächliche Daten. Wenn man dem Kanalschätzer und dem Kanalentzerrer die signalstärkekorrigierten Datensymbole zuführt, läßt sich die Bitfehlerrate bei der Entzerrung signifikant absenken.

**Patentansprüche**

1. Vorrichtung zum Signalstärkeausgleich (3) bei einer Folge empfangener digitaler Signalwerte (x(k)) in einem Mobilfunkempfänger, mit

   - Mitteln zur Signalstärkebestimmung (6), welche einen für die Signalstärke des aktuellen Signalwertes (x(k)) repräsentativen Signalstärkewert (s(k)) erzeugen,
   - Mitteln zur Berechnung eines dem aktuellen Signalwert nachgeführten Signalstärke-Mittelwertes ($\bar{s}$(k)) aus bisherigen Signalwerten der Folge,

   **gekennzeichnet durch**

   - digital arbeitende Mittel zur Signalstärkeanpassung, welche den aktuellen digitalen Signalwert (x(k)) mittels Berechnung an den bestimmten Signalstärke-Mittelwert ($\bar{s}$(k)) derart angleichen,

     -- dass ein Signalwert (x(k)), dessen Signalstärke kleiner als der nachgeführte Signalstärke-Mittelwert ($\bar{s}$(k)) ist, angehoben wird,
     -- während ein Signalwert (x(k)), dessen Signalstärke größer als der nachgeführte Signalstärke-Mittelwert ($\bar{s}$(k)) ist, abgeschwächt wird.

2. Vorrichtung nach Anspruch 1,
   **dadurch gekennzeichnet,**
   **daß** die Mittel zur Signalstärkeanpassung mindestens eine Dividiereinheit (12, 15) umfassen, die das aktuelle Signal (x(k)) durch den Signalstärke-Mittelwert ($\bar{s}$(k)) teilt.

3. Vorrichtung nach Anspruch 1 oder Anspruch 2,
   **dadurch gekennzeichnet,**
   **daß** die Mittel zur Signalstärkeanpassung den Signalstärke-Mittelwert ($\bar{s}$(k)) jeweils aus den Signalstärkewerten der bisherigen Signalwerte der Folge einschließlich des Signalstärkewertes (s(k)) des aktuellen Signalwerts bestimmen.

4. Vorrichtung nach Anspruch 1 oder Anspruch 2,
   **dadurch gekennzeichnet,**
   **daß** die Mittel zur Signalstärkeanpassung den Signalstärke-Mittelwert ($\bar{s}$(k)) jeweils aus den Signalstärkewerten der bisherigen Signalwerte der Folge ohne den Signalstärkewert (s(k)) des aktuellen Signalwertes bestimmen.

5. Vorrichtung nach einem der vorhergehenden Ansprüche,
   **dadurch gekennzeichnet,**
   **daß** es sich bei den empfangenen Signalwerten (x(k)) um komplexe Signale handelt, die jeweils ein Inphase-Signal (i(k)) und ein Quadratur-Signal (q(k)) umfassen.

6. Vorrichtung nach Anspruch 5,
   **dadurch gekennzeichnet,**
   **daß** die Mittel zur Signalstärkeanpassung das Inphase-Signal (i(k)) und das Quadratur-Signal (q(k)) durch den Signalstärke-Mittelwert ($\bar{s}$(k)) teilen.

7. Vorrichtung nach einem der Ansprüche 5 oder 6,
   **dadurch gekennzeichnet,**
   **daß** die Mittel zur Signalstärkebestimmung (6) den für die Signalstärke eines Signalwertes repräsentativen Signalstärkewert (s(k)) durch Addition des Betrags des Inphase-Signals (i(k)) und des Betrags des Quadratur-Signals (q(k)) bestimmen.

8. Vorrichtung nach einem der Ansprüche 5 oder 6,
   **dadurch gekennzeichnet,**
   **daß** die Mittel zur Signalstärkebestimmung (6) den für die Signalstärke eines Signalwertes repräsentativen Signalstärkewert (s(k)) durch Addition des quadrierten Inphase-Signals (i(k)$^2$) und des quadrierten Quadratur-Signals (q(k)$^2$) bestimmen.

**9.** Vorrichtung nach einem der vorhergehenden Ansprüche,
**dadurch gekennzeichnet,**
**daß** die Mittel zur Berechnung eines dem aktuellen Signalwert nachgeführten Signalstärke-Mittelwertes ($\bar{s}(k)$) einen Addierer (10) umfassen, der den Signalstärke-Mittelwert ($\bar{s}(k)$) durch Addieren des mit $\lambda_1$ multiplizierten vorhergehenden Signalstärke-Mittelwerts ($\bar{s}(k-1)$) und des mit $\lambda_2$ multiplizierten Signalstärkewerts ($s(k)$) des aktuellen Signalwertes erzeugt, wobei $\lambda_1+\lambda_2=1$ gilt.

**10.** Vorrichtung nach Anspruch 9,
**dadurch gekennzeichnet,**
**daß** die Mittel zur Berechnung eines dem aktuellen Signalwert nachgeführten Signalstärke-Mittelwertes ($\bar{s}(k)$) ein Register (8) für den Signalstärke-Mittelwert umfassen, welches jeweils den aktuellen Signalstärke-Mittelwert ($\bar{s}(k)$) speichert und für die Berechnung des nächstfolgenden Signalstärke-Mittelwerts ($\bar{s}(k+1)$) zur Verfügung stellt.

**11.** Vorrichtung nach Anspruch 9 oder Anspruch 10,
**dadurch gekennzeichnet,**
**daß** $\lambda_1=1-2^{-n}$ und $\lambda_2=2^{-n}$ gewählt wird, wobei n eine natürliche Zahl ist.

**12.** Vorrichtung nach Anspruch 11,
**dadurch gekennzeichnet,**
**daß** die Multiplikation des Signalstärkewerts ($s(k)$) des aktuellen Signalwertes mit $\lambda_2=2^{-n}$ mittels eines Schieberegisters (27) erfolgt.

**13.** Vorrichtung nach Anspruch 11 oder Anspruch 12,
**dadurch gekennzeichnet,**
**daß** die Multiplikation des vorhergehenden Signalstärke-Mittelwerts ($\bar{s}(k-1)$) mit $\lambda_1=1-2^{-n}$ mittels eines Addierers (28) und eines Schieberegisters (31) erfolgt.

**14.** Vorrichtung nach einem der vorhergehenden Ansprüche,
**dadurch gekennzeichnet,**
**daß** die Mittel zur Signalstärkeanpassung das aktuelle Signal ($x(k)$) nur dann an den Signalstärke-Mittelwert ($\bar{s}(k)$) angleichen, wenn die Variation der Signalstärke innerhalb der Folge eine vorgegebene Schwelle überschreitet.

**15.** Vorrichtung nach einem der vorhergehenden Ansprüche,
**dadurch gekennzeichnet,**
**daß** die Mittel zur Signalstärkeanpassung die jeweiligen aktuellen Signalwerte einer Folge nur dann an die jeweiligen Signalstärke-Mittelwerte ($\bar{s}(k)$) der Folge angleichen, wenn sich der maximale Signalstärke-Mittelwert ($\bar{s}_{max}$) der Folge und der mittlere Signalstärke-Mittelwert ($\bar{s}_{mean}$) der Folge hinreichend stark unterscheiden.

**16.** Vorrichtung nach einem der vorhergehenden Ansprüche,
**dadurch gekennzeichnet,**
**daß** die Mittel zur Signalstärkeanpassung die jeweiligen aktuellen Signalwerte einer Folge nur dann an die jeweiligen Signalstärke-Mittelwerte ($\bar{s}(k)$) der Folge angleichen, wenn der Quotient des maximalen Signalstärke-Mittelwerts ($\bar{s}_{max}$) der Folge und des mittleren Signalstärke-Mittelwerts ($\bar{s}_{mean}$) der Folge einen vorgegebenen Schwellenwert (t) überschreitet.

**17.** Empfangseinheit für die Mobilfunkübertragung, welche aufweist

- einen Kanalschätzer (1), der die Kanalkoeffizienten $h_0,...h_L$ zur Modellierung des Übertragungskanals ermittelt,
- einen Kanalentzerrer (2), der unter Verwendung der vom Kanalschätzer ermittelten Kanalkoeffizienten die empfangenen Signale entzerrt,
- eine dem Kanalschätzer (1) und dem Kanalentzerrer (2) vorgeschaltete Vorrichtung zum Signalstärkeausgleich (3) nach einem der Ansprüche 1 bis 16, welcher empfangene digitale Datensymbole ($x(k)$) zugeführt werden und welche dem Kanalschätzer (1) und dem Kanalentzerrer (2) signalstärkeangepasste Datensymbole ($\bar{x}(k)$) zuführt, wobei die Vorrichtung zum Signalstärkeausgleich (3),

-- Mitteln zur Signalstärkebestimmung (6), welche einen für die Signalstärke des aktuellen Signalwertes ($x(k)$) repräsentativen Signalstärkewert ($s(k)$) erzeugen,
-- Mitteln zur Berechnung eines dem aktuellen Signalwert nachgeführten Signalstärke-Mittelwertes ($\bar{s}(k)$)

aus bisherigen Signalwerten der Folge,

umfasst,
**dadurch gekennzeichnet,**
**daß** die Vorrichtung zum Signalstärkeausgleich (3) digital arbeitende Mittel zur Signalstärkeanpassung umfasst, welche den aktuellen digitalen Signalwert (x(k)) mittels Berechnung an den bestimmten Signalstärke-Mittelwert ($\bar{s}$(k)) derart angleichen,

- **dass** ein Signalwert (x(k)), dessen Signalstärke kleiner als der nachgeführte Signalstärke-Mittelwert ($\bar{s}$(k)) ist, angehoben wird,
- während ein Signalwert (x(k)), dessen Signalstärke größer als der nachgeführte Signalstärke-Mittelwert ($\bar{s}$(k)) ist, abgeschwächt wird.

18. Verfahren zum Signalstärkeausgleich bei einer Folge von empfangenen digitalen Signalwerten, mit den Schritten:

a) Ermitteln eines für die Signalstärke des aktuellen Signalwertes repräsentativen Signalstärkewerts (s(k));
b) Bestimmen eines dem aktuellen Signalwert nachgeführten Signalstärke-Mittelwerts ($\bar{s}$(k)) aus bisherigen Signalwerten der Folge;
c) Angleichen des aktuellen digitalen Signalwertes (x(k)) an den in Schritt b) bestimmten Signalstärke-Mittelwert ($\bar{s}$(k)) mittels digitaler Berechnung derart,

- dass ein Signalwert (x(k)), dessen Signalstärke kleiner als der nachgeführte Signalstärke-Mittelwert ($\bar{s}$(k)) ist, angehoben wird,
- während ein Signalwert (x(k)), dessen Signalstärke größer als der nachgeführte Signalstärke-Mittelwert ($\bar{s}$(k)) ist, abgeschwächt wird.

19. Verfahren nach Anspruch 18,
**dadurch gekennzeichnet,**
**daß** der aktuelle Signalwert (x(k)) an den in Schritt b) bestimmten Signalstärke-Mittelwert ($\bar{s}$(k)) angeglichen wird, indem er durch den Signalstärke-Mittelwert ($\bar{s}$(k)) dividiert wird.

20. Verfahren nach Anspruch 18 oder Anspruch 19,
**dadurch gekennzeichnet,**
**daß** der Signalstärke-Mittelwert ($\bar{s}$(k)) jeweils aus den Signalstärkewerten der bisherigen Signalwerte der Folge einschließlich des Signalstärkewerts (s(k)) des aktuellen Signalwertes bestimmt wird.

21. Verfahren nach Anspruch 18 oder Anspruch 19,
**dadurch gekennzeichnet,**
**daß** der Signalstärke-Mittelwert ($\bar{s}$(k)) jeweils aus den Signalstärkewerten der bisherigen Signalwerte der Folge ohne den Signalstärkewert (s(k)) des aktuellen Signalwertes bestimmt wird, wobei Schritt a) wahlweise vor oder nach Schritt b) ausgeführt werden kann.

22. Verfahren nach einem der Ansprüche 18 bis 21,
**dadurch gekennzeichnet,**
**daß** es sich bei den empfangenen Signalwerten um komplexe Signale handelt, die jeweils ein Inphase-Signal (i(k)) und ein Quadratur-Signal (q(k)) umfassen.

23. Verfahren nach Anspruch 22,
**dadurch gekennzeichnet,**
**daß** der aktuelle Signalwert (x(k)) an den in Schritt b) bestimmten Signalstärke-Mittelwert ($\bar{s}$(k)) angeglichen wird, indem sowohl das Inphase-Signal (i(k)) als auch das Quadratur-Signal (q(k)) durch den Signalstärke-Mittelwert ($\bar{s}$(k)) dividiert wird.

24. Verfahren nach Anspruch 22 oder Anspruch 23,
**dadurch gekennzeichnet,**
**daß** der für die Signalstärke eines Signalwerts repräsentative Signalstärkewert (s(k)) durch Addition des Betrags des Inphase-Signals (i(k)) und des Betrags des Quadratur-Signals (q(k)) bestimmt wird.

**25.** Verfahren nach Anspruch 22 oder Anspruch 23,
**dadurch gekennzeichnet,**
**daß** der für die Signalstärke eines Signalwertes repräsentative Signalstärkewert (s(k)) durch Addition des quadrierten Inphase-Signals (i(k)$^2$) und des quadrierten Quadratur-Signals (q(k)$^2$) bestimmt wird.

**26.** Verfahren nach einem der Ansprüche 18 bis 25,
**dadurch gekennzeichnet,**
**daß** der Signalstärke-Mittelwert ($\bar{s}$(k)) durch Addition des mit $\lambda_1$ multiplizierten vorhergehenden Signalstärke-Mittelwerts ($\bar{s}$(k - 1)) und des mit $\lambda_2$ multiplizierten Signalstärkewerts (s(k)) des aktuellen Signalwertes bestimmt wird, wobei $\lambda_1 + \lambda_2 = 1$ gilt.

**27.** Verfahren nach Anspruch 26,
**dadurch gekennzeichnet,**
**daß** $\lambda_1 = 1 - 2^{-n}$ und $\lambda_2 = 2^{-n}$ gewählt wird, wobei n eine natürliche Zahl ist.

**28.** Verfahren nach einem der Ansprüche 18 bis 27,
**dadurch gekennzeichnet,**
**daß** der aktuelle Signalwert (x(k)) nur dann an den in Schritt b) bestimmten Signalstärke-Mittelwert ($\bar{s}$(k)) angeglichen wird, wenn die Variation der Signalstärke innerhalb der Folge eine vorgegebene Schwelle überschreitet.

**29.** Verfahren nach einem der Ansprüche 18 bis 28,
**dadurch gekennzeichnet,**
**daß** die jeweiligen aktuellen Signalwerte (x(k)) einer Folge nur an die jeweiligen Signalstärke-Mittelwerte ($\bar{s}$(k)) der Folge angeglichen werden, wenn sich der maximale Signalstärke-Mittelwert ($\bar{s}_{max}$) der Folge und der mittlere Signalstärke-Mittelwert ($\bar{s}_{mean}$) der Folge hinreichend stark unterscheiden.

**30.** Verfahren nach einem der Ansprüche 18 bis 29,
**dadurch gekennzeichnet,**
**daß** die jeweiligen aktuellen Signalwerte (x(k)) einer Folge nur an die jeweiligen Signalstärke-Mittelwerte ($\bar{s}$(k)) der Folge angeglichen werden, wenn der Quotient des maximalen Signalstärke-Mittelwerts ($\bar{s}_{max}$) der Folge und des mittleren Signalstärke-Mittelwerts ($\bar{s}_{mean}$) der Folge einen vorgegebenen Schwellenwert (t) überschreitet.

**Claims**

**1.** Apparatus for signal strength compensation (3) for a sequence of received digital signal values (x(k)) in a mobile radio receiver, having

- signal strength determination means (6) which produce a signal strength value (s(k)) which is representative of the signal strength of the current signal value (x(k)),
- means for calculating a signal strength average ($\bar{s}$(k)), tracked to the current signal value, from previous signal values in the sequence,

 **characterized by**

- digitally-operating signal strength alignment means which align the current digital signal value (x(k)) with the determined signal strength average ($\bar{s}$(k)) by means of calculation in such a way

 -- that a signal value (x(k)) whose signal strength is below the tracked signal strength average ($\bar{s}$(k)) is boosted
 -- while a signal value (x(k)) whose signal strength is above the tracked signal strength average ($\bar{s}$(k)) is attenuated.

**2.** Apparatus according to Claim 1,
**characterized**
**in that** the signal strength alignment means comprise at least one division unit (12, 15) which divides the current signal (x(k)) by the signal strength average ($\bar{s}$(k)).

3. Apparatus according to Claim 1 or Claim 2,
   **characterized**
   **in that** the signal strength alignment means determine the signal strength average ($\bar{s}(k)$) from the respective signal strength values for the previous signals in the sequence, including the signal strength value (s(k)) for the current signal.

4. Apparatus according to Claim 1 or Claim 2,
   **characterized in that** the signal strength alignment means determine the signal strength average ($\bar{s}(k)$) from the respective signal strength values for the previous signal values in the sequence without the signal strength value (s(k)) for the current signal value.

5. Apparatus according to one of the preceding claims, **characterized**
   **in that** the received signal values (x(k)) are complex signals which respectively comprise an inphase signal (i(k)) and a quadrature signal (q(k)).

6. Apparatus according to Claim 5,
   **characterized**
   **in that** the signal strength alignment means divide the inphase signal (i(k)) and the quadrature signal (q(k)) by the signal strength average ($\bar{s}(k)$).

7. Apparatus according to one of Claims 5 or 6,
   **characterized**
   **in that** the signal strength determination means (6) determine the signal strength value (s(k)) which is representative of a signal value's signal strength by adding the magnitude of the inphase signal (i(k)) and the magnitude of the quadrature signal (q(k)).

8. Apparatus according to one of Claims 5 or 6,
   **characterized**
   **in that** the signal strength determination means (6) determine the signal strength value (s(k)) which is representative of a signal value's signal strength by adding the squared inphase signal ($i(k)^2$) and the squared quadrature signal ($q(k)^2$).

9. Apparatus according to one of the preceding claims,
   **characterized**
   **in that** the means for calculating a signal strength average ($\bar{s}(k)$) tracked to the current signal value comprise an adder (10) which produces the signal strength average ($\bar{s}(k)$) by adding the previous signal strength average ($\bar{s}(k-1)$) multiplied by $\lambda_1$ and the current signal value's signal strength value (s(k)) multiplied by $\lambda_2$, where $\lambda_1+\lambda_2=1$.

10. Apparatus according to Claim 9,
    **characterized**
    **in that** the means for calculating a signal strength average ($\bar{s}(k)$) tracked to the current signal value comprise a register (8) for the signal strength average which respectively stores the current signal strength average ($\bar{s}(k)$) and makes it available for calculating the next signal strength average ($\bar{s}(k+1)$).

11. Apparatus according to Claim 9 or Claim 10,
    **characterized**
    **in that** $\lambda_1=1-2^{-n}$ and $\lambda_2=2^{-n}$ are chosen, where n is a natural number.

12. Apparatus according to Claim 11,
    **characterized**
    **in that** the signal strength value (s(k)) for the current signal value is multiplied by $\lambda_2=2^{-n}$ using a shift register (27).

13. Apparatus according to Claim 11 or Claim 12,
    **characterized**
    **in that** the previous signal strength average ($\bar{s}(k-1)$) is multiplied by $\lambda_1=1-2^{-n}$ using an adder (28) and a shift register (31).

14. Apparatus according to one of the preceding claims,

**characterized**

**in that** the signal strength alignment means align the current signal (x(k)) with the signal strength average ($\bar{s}$(k)) only if the variation in the signal strength within the sequence exceeds a prescribed threshold.

15. Apparatus according to one of the preceding claims,
**Characterized**
**in that** the signal strength alignment means align the respective current signal values in a sequence with the respective signal strength averages ($\bar{s}$(k)) for the sequence only if the maximum signal strength average ($\bar{s}_{max}$) for the sequence and the mean signal strength average ($\bar{s}_{mean}$) for the sequence differ to a sufficient extent.

16. Apparatus according to one of the preceding claims,
**characterized**
**in that** the signal strength alignment means align the respective current signal values in a sequence with the respective signal strength averages ($\bar{s}$(k)) for the sequence only if the quotient of the maximum signal strength average ($\bar{s}_{max}$) for the sequence and of the mean signal strength average ($\bar{s}_{mean}$) for the sequence exceeds a prescribed threshold value (t).

17. Reception unit for mobile radio transmission, which has

- a channel estimator (1) which ascertains the channel coefficients $h_0,...h_L$ for modelling the transmission channel,
- a channel equalizer (2) which equalizes the received signals using the channel coefficients ascertained by the channel estimator,
- a signal strength compensation apparatus (3) according to one of Claims 1 to 16 which is connected upstream of the channel estimator (1) and the channel equalizer (2) and to which received digital data symbols (x(k)) are supplied and which supplies signal-strength-aligned data symbols ($\bar{x}$(k)) to the channel estimator (1) and to the channel equalizer (2), the signal strength compensation apparatus (3) comprising

-- signal strength determination means (6) which produce a signal strength value (s(k)) which is representative of the signal strength of the current signal value (x(k)),
-- means for calculating a signal strength average ($\bar{s}$(k)), tracked to the current signal value, from previous signal values in the sequence,

**characterized**
**in that** the signal strength compensation apparatus (3) comprises digitally operating signal strength alignment means which align the current signal value (x(k)) with the determined signal strength average ($\bar{s}$(k)) by means of calculation in such a way

- that a signal value (x(k)) whose signal strength is below the tracked signal strength average ($\bar{s}$(k)) is boosted
- while a signal value (x(k)) whose signal strength is above the tracked signal strength average ($\bar{s}$(k)) is attenuated.

18. Method for signal strength compensation for a sequence of received digital signal values, having the following steps:

a) a signal strength value (s(k)) which is representative of the signal strength of the current signal value is ascertained;
b) a signal strength average ($\bar{s}$(k)) tracked to the current signal value is determined from previous signal values in the sequence;
c) the current digital signal value (x(k)) is aligned with the signal strength average ($\bar{s}$(k)) determined in step b) by means of digital calculation in such a way

- that a signal value (x(k)) whose signal strength is below the tracked signal strength average ($\bar{s}$(k)) is boosted
- while a signal value (x(k)) whose signal strength is above the tracked signal strength average ($\bar{s}$(k)) is attenuated.

19. Method according to Claim 18,

**characterized**

**in that** the current signal value (x(k)) is aligned with the signal strength average ($\bar{s}(k)$) determined in step b) by dividing it by the signal strength average ($\bar{s}(k)$).

**20.** Method according to Claim 18 or Claim 19,
**characterized**
**in that** the signal strength average ($\bar{s}(k)$) is determined from the respective signal strength values for the previous signal values in the sequence, including the signal strength value (s(k)) for the current signal value.

**21.** Method according to Claim 18 or Claim 19,
**characterized**
**in that** the signal strength average ($\bar{s}(k)$) is determined from the respective signal strength values for the previous signal values in the sequence without the signal strength value (s(k)) for the current signal value, with step a) being able to be executed either before or after step b).

**22.** Method according to one of Claims 18 to 21,
**characterized**
**in that** the received signal values are complex signals which respectively comprise an inphase signal (i(k)) and a quadrature signal (q(k)).

**23.** Method according to Claim 22,
**characterized**
**in that** the current signal value (x(k)) is aligned with the signal strength average ($\bar{s}(k)$) determined in step b) by dividing both the inphase signal (i(k)) and the quadrature signal (q(k)) by the signal strength average ($\bar{s}(k)$).

**24.** Method according to Claim 22 or Claim 23,
**characterized**
**in that** the signal strength value (s(k)) which is representative of a signal value's signal strength is determined by adding the magnitude of the inphase signal (i(k)) and the magnitude of the quadrature signal (q(k)).

**25.** Method according to Claim 22 or Claim 23,
**characterized**
**in that** the signal strength value (s(k)) which is representative of a signal value's signal strength is determined by adding the squared inphase signal ($i(k)^2$) and the squared quadrature signal ($q(k)^2$).

**26.** Method according to one of Claims 18 to 25,
**characterized**
**in that** the signal strength average ($\bar{s}(k)$) is determined by adding the previous signal strength average ($\bar{s}(k-1)$) multiplied by $\lambda_1$ and the current signal value's signal strength value (s(k)) multiplied by $\lambda_2$, where $\lambda_1+\lambda_2=1$.

**27.** Method according to Claim 26,
**characterized**
**in that** $\lambda_1=1-2^{-n}$ and $\lambda_2=2^{-n}$ are chosen, where n is a natural number.

**28.** Method according to one of Claims 18 to 27,
**characterized**
**in that** the current signal value (x(k)) is aligned with the signal strength average ($\bar{s}(k)$) determined in step b) only if the variation in the signal strength within the sequence exceeds a prescribed threshold.

**29.** Method according to one of Claims 18 to 28,
**characterized**
**in that** the respective current signal values (x(k)) in a sequence are aligned with the respective signal strength averages ($\bar{s}(k)$) for the sequence only if the maximum signal strength average ($\bar{s}_{max}$) for the sequence and the mean signal strength average ($\bar{s}_{mean}$) for the sequence differ to a sufficient extent.

**30.** Method according to one of claims 18 to 29,
**characterized**
**in that** the respective current signals (x(k)) in a sequence are aligned with the respective signal strength averages

($\bar{s}$(k)) for the sequence only if the quotient of the maximum signal strength average ($\bar{s}_{max}$) for the sequence and of the mean signal strength average ($\bar{s}_{mean}$) for the sequence exceeds a prescribed threshold value (t).

**Revendications**

1.  Dispositif pour la compensation d'intensité de signal (3) d'une séquence de valeurs (x(k)) numériques reçues de signal dans un récepteur de téléphonie mobile, comprenant:

    -   des moyens pour la détermination de l'intensité des signal (6) produisant une valeur (s(k)) d'intensité des signal représentative de l'intensité de la valeur (x(k)) actuelle du signal,
    -   des moyens pour le calcul d'une valeur (s(k)) moyenne de l'intensité des signal venant après la valeur actuelle du signal à partir des valeurs des signal de la séquence, prises jusqu'ici

    **caractérisé par**

    -   des moyens à fonctionnement numérique pour l'adaptation de l'intensité des signal, qui adaptent la valeur (x(k)) numérique actuelle du signal par calcul, à la valeur (s(k)) moyenne déterminée de l'intensité des signal de la manière suivante

        --  une valeur (x(k)) de signal dont l'intensité est plus petite que la valeur (s(k)) moyenne des signal mise à jour est augmentée,
        --  tandis qu'une valeur (s(k)) de signal, dont l'intensité est plus forte que la valeur moyenne mise à jour est diminuée.

2.  Dispositif selon la revendication 1,
    **caractérisé en ce que**
    les moyens d'adaptation de l'intensité des signal comprennent au moins un diviseur (12,15) qui divise le signal (x(k)) actuel par la valeur (s(k)) moyenne de l'intensité des signal.

3.  Dispositif selon la revendication 1 ou 2,
    **caractérisé par le fait que**
    les moyens d'adaptation de l'intensité des signal déterminent la valeur (s(k)) moyenne de l'intensité des signal respectivement à partir des valeurs d'intensité des signal de la séquence prises jusqu'ici, y compris la valeur (s(k)) d'intensité du signal actuel.

4.  Dispositif selon la revendication 1 ou 2,
    **caractérisé par le fait que**
    les moyens d'adaptation de l'intensité des signal déterminent la valeur (s(k)) moyenne d'intensité des signal respectivement à partir des valeurs d'intensité des signal de la séquence prises jusqu'ici sans déterminer la valeur (s(k)) d'intensité du signal actuel.

5.  Dispositif selon l'une quelconque des revendications précédentes,
    **caractérisé par le fait que**
    les valeurs (x(k)) des signal reçus sont des signal complexes comprenant respectivement un signal en phase (i(k)) et un signal de quadrature (q(k)).

6.  Dispositif selon la revendication 5,
    **caractérisé par le fait que**
    les moyens d'adaptation de l'intensité des signal divisent le signal en phase (i(k)) et le signal de quadrature (q(k)) par la valeur (s(k)) moyenne de l'intensité des signal.

7.  Dispositif selon l'une des revendications 5 ou 6,
    **caractérisé par le fait que**
    les moyens de détermination de l'intensité des signal (6) déterminent la valeur (s(k)) d'intensité d'un signal (s(k)) représentatif de l'intensité d'un signal par l'addition de la valeur du signal en phase (i(k)) et de la valeur du signal de quadrature (q(k)).

**8.** Dispositif selon l'une des revendications 5 ou 6,
**caractérisé par le fait que**
les moyens de détermination de l'intensité des signal (6) déterminent la valeur d'intensité d'un signal (s(k)) représentatif de l'intensité d'un signal par l'addition du signal en phase au carré ($i(k)^2$) et du signal de quadrature au carré ($q(k)^2$).

**9.** Dispositif selon l'une quelconque des revendications précédentes,
**caractérisé par le fait que**
les moyens de calcul d'une valeur (s(k)) moyenne d'intensité des signal, venant après la valeur actuelle des signal, comprennent un additionneur (10) qui calcule la valeur (s(k)) moyenne d'intensité des signal par l'addition de la valeur

$$\left(\overline{s}(k-1)\right)$$

moyenne d'intensité du signal précédent multipliée par $\lambda_1$ et de la valeur (s(k)) d'intensité du signal actuelle multipliée par $\lambda_2$, avec $\lambda_1 + \lambda_2 = 1$.

**10.** Dispositif selon la revendication 9,
**caractérisé par le fait que**
les moyens de calcul d'une valeur (s(k)) moyenne d'intensité d'un signal, venant après la valeur actuelle du signal, comprennent un registre (8) de la valeur moyenne d'intensité des signal, qui mémorise respectivement la valeur (s(k)) moyenne d'intensité du signal qu'elle met à disposition pour le calcul de la valeur

$$\left(\overline{s}(k+1)\right)$$

d'intensité moyenne du signal suivant.

**11.** Dispositif selon la revendication 9 ou 10,
**caractérisé par le fait que**
l'on choisit $\lambda_1 = 1-2^{-n}$ et $\lambda_2 = 2^{-n}$, n étant un nombre entier naturel.

**12.** Dispositif selon la revendication 11,
**caractérisé par le fait que**
la multiplication de la valeur (s(k)) de l'intensité du signal de la valeur actuelle du signal par $\lambda_2 = 2^{-n}$ est effectuée à l'aide d'un registre à décalage (27).

**13.** Dispositif selon la revendication 11 ou 12,
**caractérisé par le fait que**
la multiplication de la valeur

$$\left(\overline{s}(k-1)\right)$$

moyenne de l'intensité du signal précédent avec $\lambda_1 = 1-2^{-n}$ est effectuée à l'aide d'un additionneur (28) et d'un registre à décalage (31).

**14.** Dispositif selon l'une quelconque des revendications précédentes,
**caractérisé par le fait que**
les moyens d'adaptation de l'intensité des signal n'adaptent le signal actuel (x(k)) à la valeur (s(k)) moyenne des signal que si l'écart d'intensité du signal à l'intérieur de la séquence dépasse un seuil donné.

**15.** Dispositif selon l'une quelconque des revendications précédentes,
**caractérisé par le fait que**

les moyens d'adaptation de l'intensité des signal n'adaptent les valeurs actuelles respectives des signal d'une séquence aux valeurs (s(k)) moyennes d'intensité des signal respectives d'une séquence que si la valeur moyenne

$$\left(\overline{s}_{max}\right)$$

d'intensité des signal maximale d'une séquence et la valeur

$$\left(\overline{s}_{mean}\right)$$

moyenne de la moyenne d'intensité d'une séquence diffèrent suffisamment.

16. Dispositif selon l'une quelconque des revendications précédentes, **caractérisé par le fait que** les moyens d'adaptation de l'intensité des signal n'adaptent les valeurs actuelles respectives des signal d'une séquence aux valeurs (s(k)) moyennes d'intensité respectives des signal d'une séquence que si le quotient de la valeur

$$\left(\overline{s}_{max}\right)$$

moyenne d'intensité des signal maximale de la séquence et la valeur

$$\left(\overline{s}_{mean}\right)$$

moyenne de la moyenne d'intensité de la séquence dépasse un seuil donné (t).

17. Unité de réception pour la transmission de téléphonie mobile, qui comprend:

- un dispositif d'évaluation des canaux (1), qui détermine les coefficients des canaux $h_0$, ... $h_L$ pour la modélisation du canal de transmission,
- un égalisateur des canaux (2), qui compense les signal reçus en utilisant les coefficients des canaux déterminés par le dispositif d'évaluation des canaux,
- un dispositif de compensation d'intensité des signal (3) installé en amont du dispositif d'évaluation des canaux (1) et de l'égalisateur des canaux (2) conformément à l'une des revendications 1 à 16, auquel sont envoyés les symboles des données numériques reçues (x(k)) et qui transmet des symboles de données à intensité des signal adaptée

$$\left(\overline{x(k)}\right)$$

au dispositif d'évaluation des canaux (1) et à l'égalisateur des canaux (2), le dispositif pour l'adaptation d'intensité des signal (3) comprenant

- - des moyens pour la détermination de l'intensité des signal (6), qui produisent une valeur (s(k)) d'intensité du signal représentative de l'intensité d'une valeur (x(k)) d'un signal actuel,
- - des moyens pour le calcul d'une valeur

$$\left(\overline{s(k)}\right)$$

moyenne d'intensité des signal venant après la valeur actuelle des signal à partir des valeurs des signal de la séquence, prises jusqu'ici

**caractérisé par le fait que**

le dispositif de compensation d'intensité (3) comprend des moyens à fonctionnement numérique pour l'adaptation de l'intensité des signal qui adaptent la valeur (x(k)) numérique actuelle du signal par calcul à une valeur

$$\left(\overline{s(k)}\right)$$

moyenne d'intensité des signal donnée de la manière suivante :

- une valeur (x(k)) de signal dont l'intensité est plus petite que la valeur

$$\left(\overline{s(k)}\right)$$

moyenne des signal mise à jour est augmentée,
- tandis qu'une valeur (x(k)) de signal dont l'intensité est plus grande que la valeur

$$\left(\overline{s(k)}\right)$$

moyenne mise à jour est diminuée.

18. Procédé pour la compensation d'intensité des signal d'une séquence de valeurs numériques de signal reçus, comprenant les étapes:

a) Détermination d'une valeur (s(k)) d'intensité du signal, représentative de l'intensité de la valeur d'un signal actuelle ;
b) Détermination d'une valeur

$$\left(\overline{s(k)}\right)$$

moyenne d'intensité à partir des valeurs prises jusqu'ici des signal de la séquence venant après la valeur actuelle du signal ;
c) Adaptation de la valeur (x(k)) numérique actuelle du signal à la valeur

$$\left(\overline{s(k)}\right)$$

moyenne d'intensité déterminée lors de l'étape b) à l'aide de calculs numériques de la manière suivante

- une valeur (x(k)) de signal dont l'intensité est plus petite que la valeur moyenne

$$\left(\overline{s(k)}\right)$$

des signal mise à jour est augmentée,
- tandis qu'une valeur (x(k)) de signal dont l'intensité est plus grande que la valeur

$$\left(\overline{s(k)}\right)$$

moyenne mise à jour est diminuée.

**19.** Procédé selon la revendication 18
**caractérisé par le fait que**
la valeur (x(k)) actuelle du signal est adaptée à la valeur

$$\left(\overline{s(k)}\right)$$

moyenne d'intensité du signal déterminée dans l'étape b) par une division par la valeur

$$\left(\overline{s(k)}\right)$$

moyenne d'intensité du signal.

**20.** Procédé selon la revendication 18 ou 19
**caractérisé par le fait que**
la valeur

$$\left(\overline{s(k)}\right)$$

moyenne d'intensité du signal est respectivement déterminée à partir des valeurs des signal de la séquence prises jusqu'ici, y compris la valeur (s(k)) d'intensité du signal de la valeur actuelle.

**21.** Procédé selon la revendication 18 ou 19,
**caractérisé par le fait que**
la valeur

$$\left(\overline{s(k)}\right)$$

moyenne d'intensité du signal est respectivement déterminée à partir des valeurs des signal de la séquence, prises jusqu'ici sans détermination de la valeur (s(k)) d'intensité actuelle du signal en effectuant au choix soit l'étape a) soit l'étape b) en premier.

**22.** Procédé selon l'une quelconque des revendications 18 à 21,
**caractérisé par le fait que**
les valeurs des signal reçus sont des signal complexes comprenant respectivement un signal en phase (i(k)) et un signal de quadrature (q(k)).

**23.** Procédé selon la revendication 22,
**caractérisé par le fait que**
la valeur (x(k)) du signal actuel est adaptée à la valeur

$$\left(\overline{s(k)}\right)$$

moyenne d'intensité du signal, déterminée par l'étape b), en divisant le signal en phase (i(k) tout comme le signal de quadrature (q(k)) par la valeur

$$\left(\overline{s(k)}\right)$$

moyenne d'intensité des signal.

**24.** Procédé selon la revendication 22,
**caractérisé par le fait que**
la valeur (s(k)) représentative de l'intensité d'un signal est déterminée par l'addition de la valeur du signal en phase (i(k)) et de la valeur du signal de quadrature (q(k)).

**25.** Procédé selon la revendication 22 ou 23,
**caractérisé par le fait que**
la valeur (s(k)) d'intensité d'un signal, représentatif de l'intensité d'un signal est déterminée par l'addition du signal en phase au carré $(i(k)^2)$ et du signal de quadrature au carré $(q(k)^2)$.

**26.** Procédé selon l'une quelconque des revendications 18 à 25,
**caractérisé par le fait que**
la valeur

$$\left(\overline{s(k)}\right)$$

moyenne d'intensité d'un signal est déterminée par addition de la précédente valeur

$$\left(\overline{s(k-1)}\right)$$

moyenne d'intensité du signal multipliée par $\lambda_1$ et de la valeur (s(k)) d'intensité du signal actuelle multipliée par $\lambda_2$, avec $\lambda_1 + \lambda_2 = 1$.

**27.** Procédé selon la revendication 26,
**caractérisé par le fait**
**que** l'on choisit $\lambda_1 = 1-2^{-n}$ et $\lambda_2 = 2^{-n}$, n étant un nombre entier naturel.

**28.** Procédé selon l'une quelconque des revendications 18 à 27
**caractérisé par le fait que**
la valeur (x(k)) du signal actuel n'est adaptée à la valeur

$$\left(\overline{s(k)}\right)$$

moyenne d'intensité d'un signal déterminée dans l'étape b) que si l'écart d'intensité du signal à l'intérieur de la séquence dépasse le seuil défini.

**29.** Procédé selon l'une quelconque des revendications 18 à 28,
**caractérisé par le fait que**
les valeurs (x(k)) actuelles respectives des signal d'une séquence ne sont adaptées aux valeurs

$$\left(\overline{s(k)}\right)$$

moyennes d'intensité des signal de la séquence que si la valeur

$$\left(\overline{s}_{\max}\right)$$

moyenne de l'intensité des signal maximale de la séquence diffère suffisamment de la valeur

$$\left(\overline{s}_{mean}\right)$$

moyenne de la moyenne de l'intensité des signal de la séquence.

30. Procédé selon l'une quelconque des revendications 18 à 29,
**caractérisé par le fait qu'**
une adaptation des valeurs (x(k)) actuelles respectives des signal d'une séquence aux valeurs

$$\left(\overline{s}(k)\right)$$

moyennes d'intensité des signal respectifs d'une séquence n'est effectuée que si le quotient de la valeur

$$\left(\overline{s}_{\max}\right)$$

moyenne d'intensité des signal maximale de la séquence par la valeur

$$\left(\overline{s}_{mean}\right)$$

moyenne de la moyenne d'intensité de la séquence dépasse un seuil donné (t).

x(1),...x(K)　　　　　　　　　　u(1),...u(K)

2

h₀,....h_L

x(1),...x(K)　　　1　　　m(K₁),...m(K₂)

## Fig.1
Stand der Technik

x(k)　　　3　　　x̄(k)　　　5　　　u(k)

h₀,....h_L

4　　　m(K₁),...m(K₂)

x̄(k)

## Fig.2

Fig.3

Fig.4

Fig.5A

Fig.5B